(19)

(11) **EP 3 035 704 B1**

(12) **FASCICULE DE BREVET EUROPEEN**

(45) Date de publication et mention de la délivrance du brevet:
**02.01.2019 Bulletin 2019/01**

(51) Int Cl.:
***H04R 3/00*** *(2006.01)*

(21) Numéro de dépôt: **15182698.9**

(22) Date de dépôt: **27.08.2015**

(54) **SYSTÈME ET PROCÉDÉ DE PROTECTION DE HAUT-PARLEUR AUDIO**

SYSTEM UND VERFAHREN ZUM SCHUTZ VON AUDIO-LAUTSPRECHERN

SYSTEM AND METHOD FOR PROTECTING AN AUDIO SPEAKER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.12.2014 FR 1462870**

(43) Date de publication de la demande:
**22.06.2016 Bulletin 2016/25**

(73) Titulaire: **STMicroelectronics (ALPS) SAS**
**38000 Grenoble (FR)**

(72) Inventeurs:
- **FRAISSE, Christian**
  **38000 GRENOBLE (FR)**
- **NAGARI, Angelo**
  **38000 GRENOBLE (FR)**

(74) Mandataire: **Cabinet Beaumont**
**4, Place Robert Schuman**
**B.P. 1529**
**38025 Grenoble Cedex 1 (FR)**

(56) Documents cités:

| | |
|---|---|
| **EP-A1- 2 538 555** | **EP-A1- 2 712 209** |
| **WO-A2-2008/092111** | **US-A1- 2002 125 945** |
| **US-A1- 2004 178 852** | **US-A1- 2013 077 796** |

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 3 035 704 B1

Printed by Jouve, 75001 PARIS (FR)

## Description

Domaine

La présente description concerne le domaine des systèmes et procédés de protection pour haut-parleurs audio, et en particulier un circuit et un procédé pour protéger un haut-parleur audio contre des oscillations non souhaitables et contre la surchauffe.

Arrière-plan

Les dispositifs mobiles comme les téléphones mobiles, et en particulier les smartphones, sont de plus en plus souvent équipés d'amplificateurs audio de puissance relativement élevée pour piloter des haut-parleurs mains-libres et assurer une fonctionnalité audio de haute qualité. Bien que dans une mise en oeuvre on puisse utiliser un amplificateur de classe AB comme amplificateur audio, le rendement d'un tel amplificateur ne dépasse pas en général 20-25 % dans la plupart des situations pratiques, ce qui conduit à une consommation de courant élevée, ce qui est non souhaitable. Les amplificateurs de classe D offrent une solution alternative qui présente un rendement notablement supérieur à celui des amplificateurs de classe AB.

Une difficulté est que les micro-haut-parleurs qui sont utilisés généralement dans les dispositifs mobiles sont relativement fragiles et peuvent facilement être endommagés. Un micro-haut-parleur typique peut en général supporter une puissance continue inférieure à un demi-watt. En effet, les micro-haut-parleurs souffrent en général de deux limitations fonctionnelles principales.

Premièrement, il y a une limite dans l'étendue admissible de l'excursion de la membrane du haut-parleur sans endommager la membrane. Pour un micro-haut-parleur typique, l'excursion maximum autorisée est d'environ 0,4 mm. Cependant, les haut-parleurs ont en général une fréquence de résonance mécanique d'environ 1 kHz, et à cette fréquence, la limite d'excursion du haut-parleur peut être dépassée avec un signal de puissance relativement faible. Bien qu'on puisse utiliser un filtre passe-haut pour atténuer l'énergie du signal à cette fréquence de résonance et en dessous, cela aurait un effet négatif sur la qualité sonore. En outre, la fréquence de résonance mécanique peut changer de façon significative lors de conditions de fonctionnement variables, par exemple en fonction de la température, du vieillissement et des forces externes comme le blocage de l'accès du haut-parleur, ce qui signifie qu'un filtre devrait supprimer une bande de fréquences relativement large.

Deuxièmement, une surchauffe peut endommager le haut-parleur. La surchauffe se produit lorsque qu'on fournit au haut-parleur plus de puissance qu'il ne peut en dissiper. Si, par exemple, le mouvement de l'air autour du haut-parleur est empêché par un accès de haut-parleur bouché, le refroidissement du haut-parleur devient moins efficace, et une surchauffe peut avoir lieu en quelques secondes à une puissance relativement faible.

Les solutions existantes pour protéger les micro-haut-parleurs des dommages tendent à être inappropriées et/ou complexes. On a donc besoin dans la technique d'un système et d'un procédé améliorés de protection de haut-parleur.

La demande de brevet publiée sous le numéro WO2008/092111 décrit un dispositif et un procédé adaptés à piloter un signal appliqué à une charge.

Résumé

Un objet de modes de réalisation de la présente description est de répondre au moins partiellement à un ou plusieurs besoins de l'art antérieur.

Selon un aspect, on prévoit un circuit comprenant : un amplificateur audio adapté à amplifier un signal d'entrée pour générer un signal de sortie approprié pour piloter un haut-parleur ; un premier circuit adapté à générer un premier signal analogique sur la base d'un niveau de courant absorbé par le haut-parleur ; un deuxième circuit adapté à générer un deuxième signal analogique sur la base d'une tension fournie aux bornes du haut-parleur ; un troisième circuit adapté à : générer un troisième signal analogique égal à la soustraction du premier signal analogique au deuxième signal analogique ; et, lorsque le deuxième signal analogique est supérieur au premier signal analogique, modifier le signal d'entrée en soustrayant le troisième signal analogique, optionnellement après une compression partielle par un compresseur.

Selon un mode de réalisation, le premier ou le deuxième circuit est adapté pour qu'au moins l'un des premier et deuxième signaux analogiques soit normalisé par rapport à l'autre de sorte que les premier et deuxième signaux sont égaux quand le haut-parleur absorbe un courant continu.

Selon un mode de réalisation, le deuxième circuit comprend un filtre analogique adapté à décaler la phase du signal de sortie pour générer le deuxième signal analogique.

Selon un mode de réalisation, le circuit comprend le troisième signal analogique, qui est comprimé partiellement par le compresseur avant d'être soustrait du signal d'entrée.

Selon un mode de réalisation, le compresseur est adapté à rendre nul le troisième signal analogique lorsque le premier signal analogique est supérieur au deuxième signal analogique.

Selon un mode de réalisation, le compresseur comprend une ou plusieurs résistances variables dans un chemin de conduction du troisième signal analogique, la résistance desdites une ou plusieurs résistances variables étant sélectionnée de façon itérative sur la base de ladite différence.

Selon un mode de réalisation, l'amplificateur audio est un amplificateur audio de classe D.

Selon un autre aspect on prévoit un système comprenant : un haut-parleur ; un dispositif de traitement adapté à générer un flux audio numérique ; un convertisseur numérique-analogique adapté à générer le signal d'entrée sur la base du flux audio numérique ; et le circuit susmentionné adapté à piloter le haut-parleur sur la base du signal d'entrée.

Selon un autre aspect on prévoit un procédé comprenant : amplifier, par un amplificateur audio, un signal d'entrée pour générer un signal de sortie approprié pour piloter un haut-parleur ; générer, par un premier circuit, un premier signal analogique sur la base d'un niveau de courant absorbé par le haut-parleur ; générer, par un deuxième circuit, un deuxième signal analogique sur la base d'une tension fournie aux bornes du haut-parleur, en normalisant par le premier circuit ou par le deuxième circuit au moins l'un des premier et deuxième signaux analogiques par rapport à l'autre ; générer, par un troisième circuit, un troisième signal analogique égal à la soustraction du premier signal analogique au deuxième signal analogique ; et, lorsque le deuxième signal analogique est supérieur au premier signal analogique, modifier, par le troisième circuit, le signal d'entrée en soustrayant le troisième signal analogique, optionnellement après une compression partielle par un compresseur.

## Brève description des dessins

Les caractéristiques et avantages susmentionnés, et d'autres, apparaîtront clairement avec la description détaillée suivante de modes de réalisation, donnés à titre d'illustration et non de limitation, en faisant référence aux dessins joints, dans lesquels :

- la figure 1 illustre schématiquement un circuit électrique équivalent d'un haut-parleur ;
- la figure 2A est un graphique illustrant un exemple de la relation typique entre le niveau du courant et la fréquence dans un haut-parleur ;
- la figure 2B est un graphique illustrant un exemple de la relation typique entre la phase du courant et la fréquence dans un haut-parleur ;
- la figure 3 illustre schématiquement un système audio comprenant un système de protection de haut-parleur selon un exemple de réalisation de la présente description ;
- la figure 4 illustre schématiquement un système d'amplification et de protection de la figure 3 plus en détail selon un exemple de réalisation ;
- la figure 5 illustre schématiquement le système d'amplification et de protection de la figure 3 plus en détail selon un autre exemple de réalisation ;
- la figure 6 illustre schématiquement un circuit de compression et de commande de la figure 5 plus en détail selon un exemple de réalisation ; et
- la figure 7 est un graphique représentant le gain de contre-réaction sur la base de la commande du compresseur de la figure 6 selon un exemple de réalisation.

## Description détaillée

Dans la présente description, le terme « connecté » est utilisé pour désigner une connexion directe entre deux éléments, tandis que le terme « couplé » est utilisé pour désigner une connexion entre deux éléments qui peut être directe, ou se faire par l'intermédiaire d'un ou plusieurs autres composants comme des résistances, des condensateurs ou des transistors.

Le document WO 2008/092111 propose, afin de limiter les variations d'impédance dans la bande basse fréquence, d'ajuster la tension appliquée au haut-parleur selon un signal de contrôle. Ce signal de contrôle correspond au signal de courant ou de tension auquel on ajoute une fraction de la différence tension-courant.

La publication de A. Nagari et al. intitulée "An 8 Ω 2.5 W 1%-THD 10 4 dB(A)-Dynamic-Range Class-D Audio Amplifier With Ultra-Low EMI System and Current Sensing for Speaker Protection", IEEE Journal of Solid-State Circuits, Vol. 47, No. 12, December 2012, décrit un circuit de protection de haut-parleur qui utilise un convertisseur analogique-numérique pour convertir des mesures de courant dans un haut-parleur en valeurs numériques, et un processeur de signal numérique (DSP) pour traiter les valeurs numériques et ajuster, en réponse, le signal numérique fourni au haut-parleur.

Bien que la solution décrite dans cette publication soit relativement efficace, l'utilisation d'un DSP entraine une consommation d'énergie relativement élevée, utilise une surface relativement élevée, et ajoute de la complexité. En outre, la concaténation du logiciel du DSP pour assurer la protection du haut-parleur avec un logiciel spécifique d'un fabricant pour réaliser d'autres fonctions du DSP est une tâche complexe.

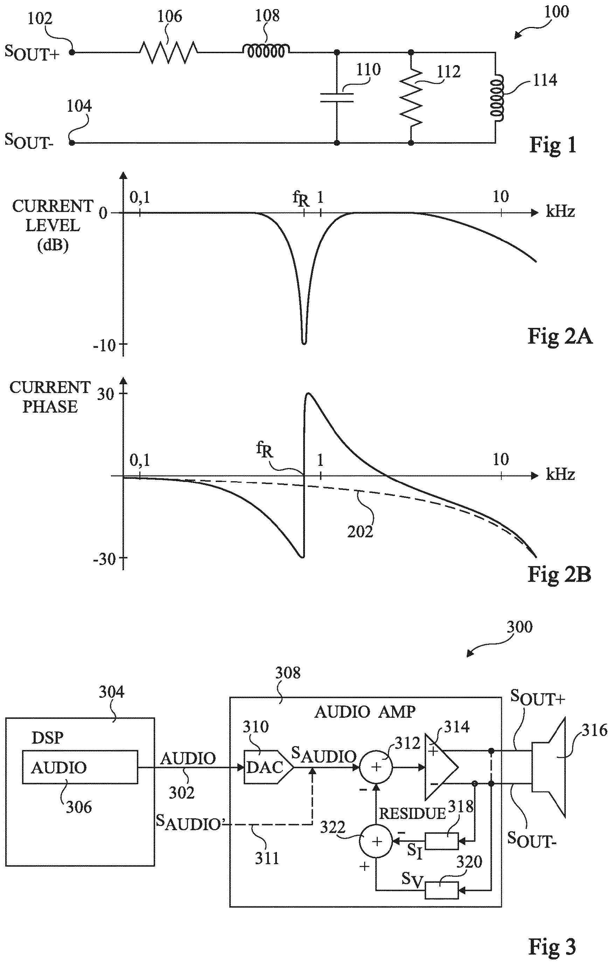

La figure 1 illustre schématiquement un circuit électrique équivalent 100 d'un haut-parleur, qui est par exemple un micro-haut-parleur d'un téléphone mobile, ayant deux bornes d'entrée 102 et 104 recevant des signaux $S_{OUT+}$ et $S_{OUT-}$ d'un amplificateur (non illustré en figure 1). Le circuit 100 comprend, couplée à la borne 102 du haut-parleur, une résistance 106 représentant une charge résistive équivalente qui varie avec la température. La résistance 106 et couplée en série avec une inductance 108. Le haut-parleur comprend aussi une partie résonnante modélisée par la connexion en parallèle d'un condensateur 110, d'une résistance 112 et d'une inductance 114, chacun d'eux étant couplé entre l'inductance 108 et la borne 104. La partie résonnante représente le comportement résonnant du haut-parleur autour d'une certaine fréquence, qui varie avec la température et en raison d'autres effets.

En supposant que le haut-parleur a une impédance nominale d'environ 8 ohms, la résistance 106 a par exemple une résistance d'environ 7,4 ohms, l'inductance 108 a une inductance comprise entre 40 et 100 μH, par exemple d'environ 60 μH, le condensateur 110

a une capacité d'environ 160 µF, la résistance 112 a une résistance d'environ 16 ohms, et l'inductance 114 a une inductance d'environ 200 µH. Tel qu'il est utilisé ici, le terme « environ » est utilisé pour désigner une plage de +/- 10 pourcent. Bien sûr, les valeurs susmentionnées ne sont que des exemples, et un tel modèle va varier considérablement d'un haut-parleur à un autre, en fonction de caractéristiques comme les dimensions et l'impédance du haut-parleur.

La figure 2A illustre un exemple de la relation entre le niveau du courant (CURRENT LEVEL), en décibels, et la fréquence, sur une échelle logarithmique en kHz, dans le haut-parleur représenté par le modèle de la figure 1. Comme cela est illustré en figure 2A, le niveau de courant reste par exemple constant à 0 dB pour des basses fréquences jusqu'à proximité de la fréquence de résonance $f_R$ du haut-parleur, où le niveau du courant descend brutalement. Dans l'exemple de la figure 2A, la fréquence de résonance $f_R$ est juste en dessous de 1 kHz, et à ce point le courant atteint par exemple un point bas de -10 dB. Au-dessus de la fréquence de résonance, le niveau du courant remonte au niveau 0 dB avant de chuter de nouveau lorsque la fréquence approche de la limite du haut-parleur à environ 20 kHz.

Selon les modes de réalisation décrits ici, pour éviter d'endommager le haut-parleur, l'énergie du signal à environ la fréquence de résonance $f_R$ est par exemple atténuée.

La figure 2B illustre un exemple de la relation entre la phase du courant (CURRENT PHASE), en degrés, et la fréquence, sur une échelle logarithmique en kHz, dans le haut-parleur représenté par le modèle de la figure 1. Une courbe en pointillés 202 en figure 2B illustre un cas dans lequel le haut-parleur ne souffre pas d'avoir une fréquence de résonance, et dans un tel cas la phase par exemple se décale progressivement avec la fréquence, atteignant par exemple un déphasage de -30 degrés à 20 kHz. Cependant, comme cela est représenté par une courbe en trait plein en figure 2B, dans le cas où le haut-parleur a une fréquence de résonance $f_R$, le déphasage par exemple diminue rapidement à proximité de cette fréquence. Juste en dessous de la fréquence de résonance $f_R$, le déphasage atteint par exemple un pic d'environ -30 degrés, puis bascule brusquement vers un déphasage positif avec un pic de 30 degrés juste au-dessus de la fréquence de résonance $f_R$. Le déphasage diminue ensuite progressivement avec l'augmentation de la fréquence, devient négatif, et atteint le niveau -30 degrés à 20 kHz.

La figure 3 illustre schématiquement un système audio 300 selon un exemple de réalisation de la présente description.

Un signal audio numérique audio est par exemple fourni sur une connexion 302 à partir d'un processeur de signal numérique (DSP) 304, par exemple sur la base d'un flux audio 306 (AUDIO) provenant d'un fichier audio mémorisé dans une mémoire (non illustrée en figure 3). La connexion 302 est couplée à un bloc amplificateur audio (AUDIO AMP) 308, et en particulier à un convertisseur numérique-analogique (DAC) 310, qui convertit le signal AUDIO en un signal de tension analogique $S_{AUDIO}$. Dans certains modes de réalisation, un signal analogique $S_{AUDIO}$' peut à la place ou en plus être fourni par l'intermédiaire d'une entrée 311 du bloc amplificateur audio 308 à partir d'une source analogique.

Le signal analogique $S_{TUDIO}$ est fourni à un élément limiteur de puissance 312, qui ajuste la puissance du signal fourni au haut-parleur sur la base d'un chemin de contre-réaction décrit ci-après. Le signal de contre-réaction, nommé RESIDUE en figure 3, correspond par exemple à la convolution temporelle du courant de haut-parleur $I_{SPKR}$ et de la tension $V_{SPKR}$, avec une pondération appropriée et un ajustement de phase approprié. En particulier, la convolution temporelle $V_{SPKR}$-$I_{SPKR}$ correspond à l'impédance $Z_{SPKR}$ dans le domaine fréquentiel. Par exemple, le signal de contre-réaction RESIDUE est soustrait du signal $S_{TUDIO}$ par l'élément 312. Cette soustraction de l'impédance $Z_{SPKR}$ du chemin de signal conduit à une égalisation en temps réel du chemin, elle-même pondérée par la réponse fréquentielle de l'impédance du haut-parleur.

La sortie de l'élément limiteur de puissance 312 est fournie à un amplificateur audio 314, qui est par exemple un amplificateur de classe D, bien que dans des variantes de réalisation on puisse utiliser d'autres types d'amplificateurs, comme un amplificateur de classe AB. L'amplificateur 314 fourni les signaux de sortie différentiels $S_{OUT+}$, $S_{OUT-}$ au haut-parleur 316, qui est par exemple un micro-haut-parleur.

Une mesure de courant est faite sur l'une des lignes de sortie de l'amplificateur audio 314, et est fournie à un circuit 318 qui génère un signal de courant analogique $S_I$, représenté par exemple par un signal de tension, sur la base du niveau de courant dans le haut-parleur. En outre, une mesure de tension est faite entre les lignes de sortie de l'amplificateur audio 314, et est fournie à un circuit 320, qui fournit un signal analogique $S_V$ sur la base de la différence de tension $V_{OUT}$ entre $S_{OUT+}$ et $S_{OUT-}$.

La mesure de courant est par exemple indépendante de la résistance en courant continu du haut-parleur, en d'autres termes elle est normalisée pour supposer une résistance unitaire. Par exemple, dans un mode de réalisation, la mesure de courant est basée sur la chute de tension dans une résistance dans l'une des lignes de sortie de l'amplificateur audio 314. Cette résistance a par exemple une résistance $R_{SENSE}$ égale à une fraction $G_{SENSE}$ de la résistance en courant continu du haut-parleur. Ainsi dans des conditions de courant continu, la mesure de courant sera égale à $G_{SENSE}*V_{OUT}$. En outre, au moins l'un des signaux de courant et de tension $S_I$, $S_V$ est par exemple normalisé par le circuit 318 ou 320, pour annuler le gain $G_{SENSE}$ appliqué à la mesure de courant, de sorte que dans des conditions de courant continu les signaux de courant et de tension vont être sensiblement égaux.

Une différence entre les signaux de courant et de tension $S_I$, $S_V$ est ensuite par exemple générée par un circuit 322, en soustrayant le signal de courant du signal de tension. Le résultat constitue le signal RESIDUE à soustraire des signaux d'entrée $S_{AUDIO}$ par l'élément 312.

Dans certains modes de réalisation, le signal RESIDUE peut-être généré en appliquant, par le circuit 322, un gain à la différence entre les signaux de courant et de tension. En outre, le signal RESIDUE est activé seulement dans le cas où le signal de tension $S_V$ est supérieur au signal de courant $S_I$, et dans l'autre cas, le signal RESIDUE et nul.

En fonctionnement, la boucle de contre-réaction analogique formée par les circuits 318, 320 et 322 et l'élément 312 assure une correction presque instantanée du niveau d'énergie du signal si une augmentation d'impédance du haut-parleur 316 est détectée, en d'autres termes si le signal de tension $S_V$ devient supérieur au signal de courant $S_I$.

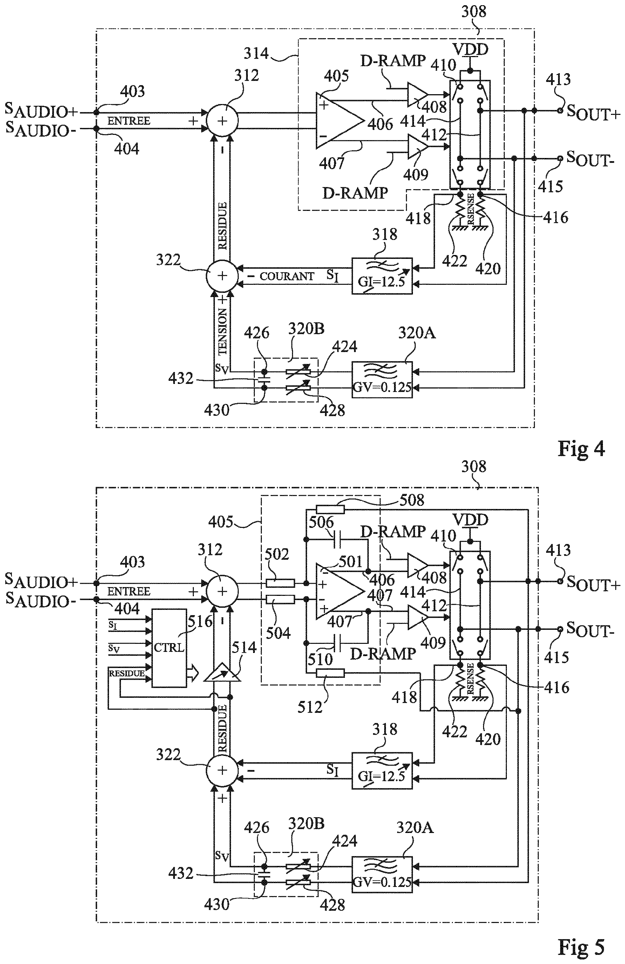

La figure 4 illustre schématiquement le bloc amplificateur audio 308 de la figure 4 plus en détail selon un exemple de réalisation.

Comme cela est représenté en figure 4, le signal audio analogique $S_{TUDIO}$ de la figure 3 est par exemple un signal différentiel $S_{AUDIO+}$, $S_{AUDIO-}$ fourni aux noeuds d'entrée correspondants 403 et 404 de l'amplificateur audio 314. Le signal $S_{TUDIO}$ peut être fourni par des sorties différentielles du DAC 310 (non illustrées en figure 4), ou par l'intermédiaire de lignes d'entrée formant l'entrée 311 de la figure 3 (également non illustrées en figure 4).

Dans l'exemple de la figure 4, l'amplificateur audio 314 est un amplificateur audio de classe D comprenant un intégrateur 405. Une sortie positive 406 de l'intégrateur 405 est couplée à une entrée d'un comparateur 408, dont l'autre entrée est couplée de façon à recevoir un signal à double rampe (D-RAMP). De façon similaire, une sortie négative 407 de l'intégrateur 405 est couplée à une entrée d'un comparateur 409, dont l'autre entrée est couplée de façon à recevoir le signal à double rampe. La sortie de chacun des comparateurs 408, 409 est couplée à un pont en H 410.

Le pont en H 410 comprend un conducteur 412 couplé à une sortie 413 du bloc amplificateur audio 308, et un conducteur 414 couplé à une sortie 415 du bloc amplificateur audio 308. Les conducteurs 412 et 414 sont couplés à la tension d'alimentation $V_{DD}$ par l'intermédiaire de commutateurs respectifs. Le conducteur 412 est aussi couplé à un noeud 416 par l'intermédiaire d'un autre commutateur, et le conducteur 414 est aussi couplé à un noeud 418 par l'intermédiaire d'encore un autre commutateur. Le noeud 416 est couplé à la masse par l'intermédiaire d'une résistance 420, et le noeud 418 est couplé à la masse par l'intermédiaire d'une résistance 422. Chacune des résistances 420, 422 a une résistance Rsense. Les sorties des comparateurs 408, 409 contrôlent les commutateurs du pont en H de telle sorte que la sortie 413 est couplée à la tension d'alimentation $V_{DD}$ et la sortie 415 est couplée à la masse par l'intermédiaire de la résistance 422, ou de telle sorte que la sortie 413 est couplée à la masse par l'intermédiaire de la résistance 420 et la sortie 415 est couplée à la tension d'alimentation $V_{DD}$.

Le circuit 318 a des entrées couplées aux noeuds 416 et 418. Dans un mode de réalisation, le gain GI d'un étage amplificateur du circuit 318 est égal à :

$$GI = G_{trim} + G_{Rdc}$$

où $G_{trim}$ est une valeur, par exemple sélectionnée dans une table de correspondance, destinée à compenser des différences entre chacune des résistances 420 et 422 et leur valeur nominale, et $G_{Rdc}$ est une valeur, par exemple sélectionnée dans une autre table de correspondance, utilisée pour compenser des différences entre la résistance en courant continu réelle du haut-parleur 316 et sa valeur nominale. Le circuit 318 comprend aussi par exemple un filtre du premier ordre pour filtrer le signal de courant analogique. Un filtre du premier ordre est par exemple suffisant puisque le courant est aussi filtré par la charge.

Le circuit 320 pour générer le signal de tension analogique $S_V$ comprend par exemple un étage amplificateur 320A ayant par exemple un gain GV d'environ 0,125. Le circuit 320A comprend aussi par exemple un filtre du deuxième ordre pour filtrer le signal de tension analogique.

Le circuit 320 comprend aussi par exemple un filtre RC variable 320B constitué d'une résistance variable 424 couplée entre une sortie de l'étage amplificateur différentiel 320A et un noeud 426, d'une résistance variable 428 couplée entre l'autre sortie de l'étage amplificateur différentiel 320A et un noeud 430, et d'un condensateur 432 couplé entre les noeuds 426 et 430.

Les résistances des résistances variables 424, 428 sont par exemple choisies de telle sorte que le filtre RC 320B compense la différence de phase entre la tension entre les bornes de sortie 413, 415, et le courant dans le haut-parleur 316, qui peut varier en fonction de l'inductance du haut-parleur 316. Par exemple, si on appelle Rle la résistance de chacune des résistances 424, 428, la valeur de Rle est par exemple adaptée pour être égale à :

$$Rle = Le/(40x10^{-12}*Rdc),$$

où Le est l'inductance du haut-parleur 316 comme cela est représenté par l'inductance 108 en figure 1, et Rdc est la résistance en courant continu du haut-parleur 316. En prenant l'exemple dans lequel Le est égale à 60 $\mu$H et Rdc est égale à 7,4 ohms, la résistance Rle est par exemple choisie égale à 202,7 kilo-ohms. Dans un environnement, chacune des résistances 424, 428 est par exemple variable autour d'une valeur d'environ 203 kilo-ohms, et le condensateur 465 a par exemple une capacité d'environ 20 pF.

La figure 5 illustre schématiquement le bloc amplificateur audio 308 de la figure 3 plus en détail selon une variante de réalisation par rapport à la figure 4. De nombreux éléments du circuit de la figure 5 sont identiques à ceux du circuit de la figure 4 et portent les mêmes références numériques et ne seront pas décrits de nouveau en détail.

La figure 5 illustre l'intégrateur 405 dans un exemple où il comprend un amplificateur différentiel 501 ayant son entrée positive couplée à une sortie de l'élément limiteur de puissance 312 par l'intermédiaire d'une résistance 502 et son entrée négative couplée à l'autre sortie de l'élément limiteur de puissance 312 par l'intermédiaire d'une résistance 504. L'amplificateur différentiel 501 a aussi son entrée positive couplée à sa sortie négative par un condensateur 506, et au noeud de sortie 413 du bloc amplificateur audio 308 par intermédiaire d'une résistance 508. De façon similaire, l'amplificateur différentiel a par exemple son entrée négative couplée à sa sortie positive par un condensateur 510, et au noeud de sortie 415 du bloc amplificateur audio 308 par une résistance 512.

En outre, dans le mode de réalisation de la figure 5, les lignes de sortie du circuit 322 sont couplées à l'élément limiteur de puissance 312 par l'intermédiaire d'un compresseur 514, qui est par exemple contrôlé par un bloc de commande (CTRL) 516. Le bloc de commande 516 sélectionne par exemple une valeur de résistance du compresseur 514 sur la base du signal de résidu, du signal de courant analogique $S_I$ fourni à la sortie du circuit 318, et du signal de tension analogique $S_V$ fourni à la sortie du circuit 320.

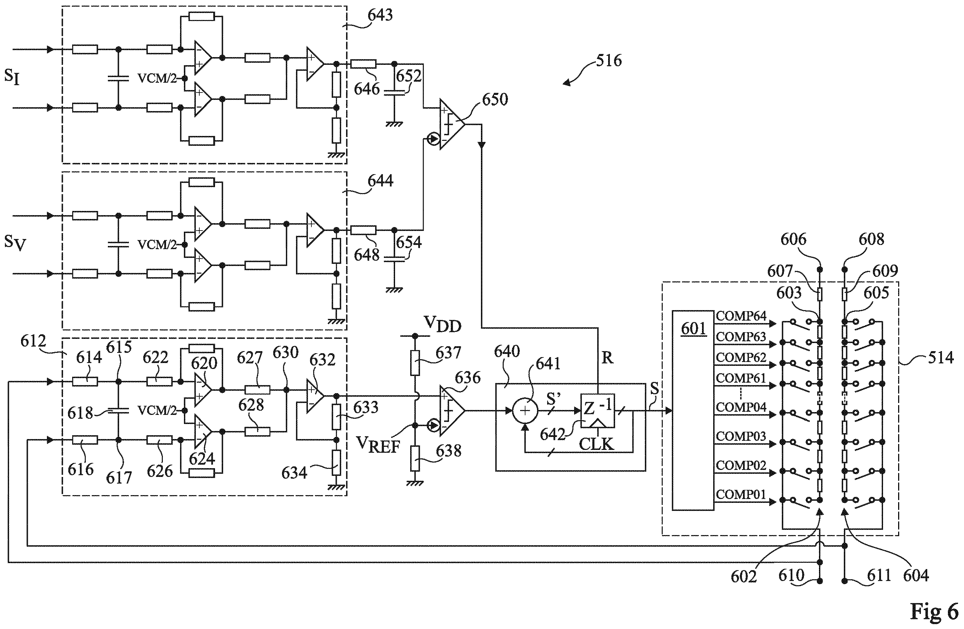

La figure 6 illustre schématiquement le compresseur 514 et le bloc de commande 516 plus en détail selon un exemple de réalisation.

Le compresseur 514 comprend par exemple un circuit de sélection 601, et une résistance variable constituée d'une série 602 de 63 résistances couplée à un noeud 603, et une autre résistance variable constituée d'une série 604 de 63 résistances couplée à un noeud 605. Le noeud 603 est par exemple couplé à une sortie 606 du compresseur 514 par l'intermédiaire d'une résistance 607, et le noeud 605 est par exemple couplé à une sortie 608 du compresseur 514 par l'intermédiaire d'une résistance 609. Bien que dans certains modes de réalisation les résistances de chacune des séries 602, 604 aient chacune la même résistance, dans l'exemple de la figure 6, la résistance de chaque série la plus proche du noeud 603, 604 a par exemple une résistance relativement faible, et la résistance des autres éléments augmente progressivement au fur et à mesure qu'ils s'éloignent des noeuds 603, 605. Un noeud 610 à l'entrée du compresseur 514, qui est couplé à une sortie du circuit 322, peut-être couplé sélectivement par l'un d'une série de 64 commutateurs à n'importe quel noeud de la série de résistances 602. Ces commutateurs sont respectivement contrôlés par des signaux de commande à 1 bit COMP01 à COMP64. De façon similaire, un noeud 611 à l'entrée du compresseur 514, qui est couplé à l'autre sortie du circuit 322, peut être couplé sélectivement par l'un d'une série de 64 commutateurs à un noeud quelconque de la série de résistances 604. Ces commutateurs sont aussi respectivement contrôlés par les signaux de commande COMP01 à COMP64.

Le bloc de sélection 601 active l'un des signaux de commande COMP01 à COMP64, ou aucun de ces signaux, sur la base d'un signal de sélection S fourni par le circuit de commande 516.

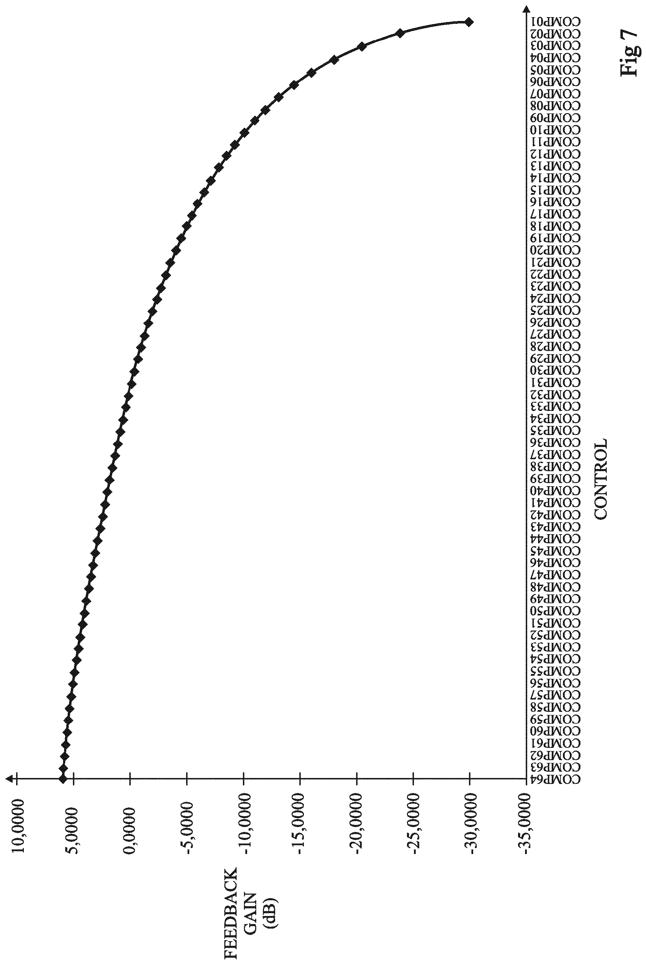

Un exemple du gain de contre-réaction fourni par la sélection de chacun des signaux de commande est illustré en figure 7.

La figure 7 est un graphique représentant le gain de contre-réaction (FEEDBACK GAIN) en décibels en fonction du signal de commande (CONTROL) appliqué au compresseur. Dans le cas où aucun des signaux de commande COMP01 à COMP64 'n' est activé, la boucle est par exemple ouverte. Le gain sélectionnable le plus faible correspondant à l'activation du signal COMP01 est par exemple d'environ -32 dB, alors que le gain le plus élevé correspondant à l'activation du signal de commande COMP64 est par exemple d'environ +6 dB. Le gain diminue par exemple de façon relativement linéaire pour les signaux de commande COMP64 à COMP20, puis diminue de façon exponentielle jusqu'à la valeur minimum. La façon dont les valeurs de résistance dans le compresseur et d'autres résistances dans le circuit peuvent être sélectionnées afin d'obtenir les gains de contre-réaction représentés en figure 7, apparaîtra facilement à l'homme de l'art. En outre, il apparaîtra clairement à l'homme de l'art qu'une loi de compression similaire, ayant une courbe similaire à celle de la figure 7, pourrait être obtenue avec un nombre de signaux de commande plus grand ou plus petit.

En référence de nouveau à la figure 6, le circuit de commande 516 comprend par exemple un étage de conversion 612, qui reçoit le signal de résidu RESIDUE à partir des noeuds d'entrée 610, 611, et fournit une conversion du mode différentiel vers le mode non différentiel. L'étage 612 comprend par exemple un filtre RC constitué d'une résistance 614 couplant la ligne 610 à un noeud 615, d'une résistance 616 couplant la ligne 611 à un noeud 617, et d'un condensateur 618 couplé entre les noeuds 615 et 617. Les résistances 614 et 616 ont par exemple des résistances d'environ 400 kilo-ohms, et le condensateur 618 a par exemple une capacité d'environ 15 pF. Le noeud 615 est couplé à une entrée négative d'un amplificateur différentiel 620 par l'intermédiaire d'une résistance 622 ayant par exemple une résistance d'environ 400 kilo-ohms. L'amplificateur différentiel 620 a par exemple un chemin de contre-réaction entre sa sortie et son entrée négative comprenant une résistance d'environ 800 kilo-ohms. De façon similaire, le noeud 617 est par exemple couplé à une entrée négative d'un amplificateur différentiel 624 par l'intermédiaire d'une résistance 626 ayant une résistance d'environ 400 kilo-ohms. L'amplificateur différentiel 624 a par exemple un chemin de contre-réaction entre sa sortie et son entrée négative comprenant une résistance d'environ 800 kilo-ohms.

Les entrées positives des amplificateurs différentiels 620, 624 sont couplées à un niveau de tension de référence égal par exemple à environ la moitié d'une tension de mode commun VCM des signaux différentiels. Chacune des sorties des amplificateurs différentiels 620, 624 est par exemple couplée, par l'intermédiaire d'une résistance respective 627, 628, à un noeud 630. Le noeud 630 est par exemple couplé à une entrée positive d'un amplificateur différentiel 632 ayant sa sortie couplée à la masse par la connexion en série de deux résistances 633, 634 ayant par exemple respectivement des résistances d'environ 1200 et 400 kilo-ohms. Un noeud intermédiaire entre les résistances 633 et 634 est couplé à l'entrée négative de l'amplificateur différentiel 632. L'amplificateur 632 fournit la valeur absolue, par exemple la valeur RMS (valeur quadratique moyenne), du résidu d'entrée différentiel du bloc 612.

La sortie du bloc 612 est couplée à l'entrée positive d'un comparateur 636, qui compare le signal à une tension de référence $V_{REF}$ générée par la connexion en série d'une résistance 637 et d'une résistance variable 638 couplées entre la tension d'alimentation $V_{DD}$ et la masse. Dans un mode de réalisation, la tension d'alimentation $V_{DD}$ est d'environ 2 V, la résistance 637 a une résistance d'environ 63 kilo-ohms, et la résistance 638 a une résistance d'environ 27 kilo-ohms, de sorte que la référence $V_{REF}$ est d'environ 0,54 V. Le comparateur 636 fournit sur sa sortie une valeur binaire, qui est par exemple haute si le signal provenant du bloc 612 est supérieur à $V_{REF}$, et basse si le signal provenant du bloc 612 est inférieur à $V_{REF}$.

La sortie du comparateur 636 est couplée à un accumulateur 640, qui est par exemple de 12 bits. L'accumulateur 640 comprend par exemple un additionneur de 12 bits 641, qui reçoit le signal binaire de sortie provenant du comparateur 636, et qui l'ajoute au signal S présent à la sortie de l'accumulateur 640 pour générer une valeur modifiée S' fournie à une bascule 642. La bascule 642 est cadencée par un signal d'horloge CLK, qui a par exemple une fréquence d'environ 48 kHz. La bascule 642 fournit par exemple le signal de sélection S sur sa sortie.

Dans un mode de réalisation, le circuit de sélection 601 génère les signaux de commande COMP01 à COMP64 sur la base des six bits les plus significatifs (MSB) de la valeur S de 12 bits. Par exemple, lorsque les 6 MSB sont tous à zéro, aucun des signaux COMP01 à COMP64 n'est activé, tandis que lorsque les six MSB sont tous à un, le signal COMP64 est sélectionné. L'additionneur 641 est par exemple adapté à additionner 32 à la valeur de 12 bits, en d'autres termes le mot binaire "0000 0010 0000", si la sortie du comparateur 636 est haute, et à soustraire 1 de la valeur de 12 bits, en d'autres termes soustraire le mot binaire "0000 0000 0001" si la sortie du comparateur 636 est basse.

La bascule 642 est par exemple remise à zéro par un signal de réinitialisation R fourni par un bloc de vérification de signe qui va maintenant être décrit. Ce bloc active par exemple le signal de réinitialisation R si le signal de courant $S_I$ est supérieur au signal de tension $S_V$, de sorte que le signal sur la sortie du bloc de compression 508 est amené à l'état bas.

Le signal de courant différentiel $S_I$ est par exemple fourni à un bloc de conversion du mode différentiel en mode non différentiel 643, qui est par exemple similaire au bloc 612, et qui ne va pas être décrit de nouveau un détail. De façon similaire, le signal de tension différentiel $S_V$ est par exemple fourni par un bloc de conversion de valeur différentielle en valeur absolue (par exemple RMS) 644, qui est aussi par exemple similaire au bloc 612, et qui ne va pas être décrit de nouveau en détail. Les sorties des blocs 643 et 644 sont fournies, par des résistances respectives 646 et 648, à des entrées respectivement positive et négative d'un comparateur 650. Les entrées positive et négative sont aussi par exemple respectivement couplées à la masse par l'intermédiaire de condensateurs 652 et 654 respectivement. Les résistances 646, 648 ont chacune par exemple une résistance d'environ 64000 kilo-ohms, et les condensateurs 652, 654 ont chacun par exemple une capacité d'environ 40 pF.

Le comparateur 650 compare par exemple les signaux d'entrée, et active le signal de réinitialisation R si le signal de courant est supérieur au signal de tension.

Un avantage du système de compression décrit dans la figure 5 est qu'il aura tendance à réduire le rapport signal sur bruit dans le système. Cela permet par exemple à l'amplificateur 314 d'être soulagé en termes de bruit rapporté à l'entrée, réduisant ainsi la consommation d'énergie et la surface de la puce.

La commande de 6 bits fournie par les circuits de compression et de commande 514, 516 limite le SNDR (rapport signal sur bruit plus distorsion) à 36 dB autour de la fréquence de résonance, ce qui correspond à une plage dynamique de 46 dB, ce qui est par exemple suffisant pour assurer un effet important de masquage psycho-acoustique de niveau de pression sonore. Dans des variantes de réalisation, une compression basée sur davantage ou sur moins de bits peut être appliquée. Par exemple, un compresseur à 7 bits donnera un SNDR de 46 dB, et une plage dynamique de 52 dB.

Un avantage des modes de réalisation décrits ici est que le circuit fournit un mécanisme de commande simple et efficace pour protéger un haut-parleur des dommages associés à une surchauffe et/ou un déplacement au-delà de ses limites d'excursion admise maximale. Les inventeurs ont trouvé que la mise en oeuvre d'un tel circuit ajoute relativement peu de consommation de courant, et une surface limitée pour le circuit supplémentaire.

Bien qu'on ait décrit et représenté dans les figures certains modes de réalisation spécifiques de l'invention, il apparaîtra clairement à l'homme de l'art que de nombreuses modifications et altérations pourraient être appliquées.

Par exemple, bien que les figures comprennent de nombreux exemples de résistances, de capacités et d'inductances, il apparaîtra clairement à l'homme de l'art qu'on peut utiliser de nombreuses valeurs différentes, en fonction de l'application spécifique.

En outre, il apparaîtra clairement à l'homme de l'art que les modes de réalisation décrits ici pourraient être adaptés à une mise en oeuvre non différentielle au lieu de différentielle.

**Revendications**

**1.** Circuit comprenant :

un amplificateur audio (314) adapté à amplifier un signal d'entrée ($S_{AUDIO}$) pour générer un signal de sortie ($S_{OUT+}$, $S_{OUT-}$) approprié pour piloter un haut-parleur (316) ;
un premier circuit (318) adapté à générer un premier signal analogique ($S_I$) sur la base d'un niveau de courant absorbé par le haut-parleur (316) ; et
un deuxième circuit (320) adapté à générer un deuxième signal analogique ($S_V$) sur la base d'une tension fournie aux bornes du haut-parleur (316),
**caractérisé en ce que** le circuit comprend en outre un troisième circuit (322, 312) adapté à :

- générer un troisième signal analogique (RESIDUE) égal à la soustraction du premier signal analogique ($S_I$) au deuxième signal analogique ($S_V$) ; et
- lorsque le deuxième signal analogique ($S_V$) est supérieur au premier signal analogique ($S_I$), modifier le signal d'entrée ($S_{AUDIO}$) en soustrayant le troisième signal analogique (RESIDUE).

**2.** Circuit selon la revendication 1, dans lequel le premier ou le deuxième circuit est adapté pour qu'au moins l'un des premier et deuxième signaux analogiques ($S_I$, $S_V$) soit normalisé par rapport à l'autre de sorte que les premier et deuxième signaux sont égaux quand le haut-parleur absorbe un courant continu.

**3.** Circuit selon les revendications 1 ou 2, dans lequel le deuxième circuit (320) comprend un filtre analogique (320B) adapté à décaler la phase du signal de sortie pour générer le deuxième signal analogique ($S_V$).

**4.** Circuit selon la revendication 3, dans lequel le troisième signal analogique (RESIDUE) est comprimé partiellement par le compresseur (514) avant de le soustraire du signal d'entrée ($S_{AUDIO}$)

**5.** Circuit selon la revendication 4, dans lequel le compresseur (514) est adapté à rendre nul le troisième signal analogique (RESIDUE) lorsque le premier signal analogique ($S_I$) est supérieur au deuxième signal analogique ($S_V$).

**6.** Circuit selon les revendications 4 ou 5, dans lequel le compresseur (514) comprend une ou plusieurs résistances variables (602, 604) dans un chemin de conduction du troisième signal analogique, la résistance desdites une ou plusieurs résistances variables étant sélectionnée de façon itérative sur la base de ladite différence.

**7.** Circuit selon l'une quelconque des revendications 1 à 6, dans lequel l'amplificateur audio (314) est un amplificateur audio de classe D.

**8.** Système comprenant :

un haut-parleur (316) ;
un dispositif de traitement (304) adapté à générer un flux audio numérique (AUDIO) ;
un convertisseur numérique-analogique (310) adapté à générer le signal d'entrée ($S_{AUDIO}$) sur la base du flux audio numérique (AUDIO) ; et
le circuit de l'une quelconque des revendications 1 à 7 adapté à piloter le haut-parleur (316) sur la base du signal d'entrée ($S_{AUDIO}$).

**9.** Procédé comprenant :

amplifier, par un amplificateur audio (314), un signal d'entrée ($S_{AUDIO}$) pour générer un signal de sortie ($S_{OUT+}$, $S_{OUT-}$) approprié pour piloter un haut-parleur (316) ;
générer, par un premier circuit (318), un premier signal analogique ($S_I$) sur la base d'un niveau de courant absorbé par le haut-parleur (316) ; et
générer, par un deuxième circuit (320), un deuxième signal analogique ($S_V$) sur la base d'une tension fournie aux bornes du haut-parleur (316), en normalisant par le premier circuit ou le deuxième circuit au moins l'un des premier et deuxième signaux analogiques par rapport à l'autre,
**caractérisé en ce que** le procédé comprend en outre :

générer, par un troisième circuit (322, 312), un troisième signal analogique (RESIDUE) égal à la soustraction du premier signal analogique ($S_I$) au deuxième signal analogique ($S_V$) ; et

lorsque le deuxième signal analogique ($S_V$) est supérieur au premier signal analogique ($S_I$), modifier, par le troisième circuit (322, 312), le signal d'entrée ($S_{AUDIO}$) en soustrayant le troisième signal analogique (RESIDUE).

**Patentansprüche**

1. Eine Schaltung, die Folgendes aufweist:

einen Audioverstärker (314), der geeignet ist zum Verstärken eines Eingangssignals ($S_{AUDIO}$) zum Erzeugen eines Ausgangssignals ($S_{OUT+}$, $S_{OUT-}$), das geeignet ist zum Ansteuern eines Lautsprechers (316);
eine erste Schaltung (318), die geeignet ist zum Erzeugen eines ersten analogen Signals ($S_I$) basierend auf einem durch den Lautsprecher (316) gezogenen Strompegel; und
eine zweite Schaltung (320), die geeignet ist zum Erzeugen eines zweiten analogen Signals ($S_V$) basierend auf einer über den Lautsprecher (316) angelegten Spannung,
**dadurch gekennzeichnet, dass** die Schaltung ferner eine dritte Schaltung (322, 312) aufweist, die geeignet ist zum:

- Erzeugen eines dritten analogen Signals (RESIDUE) gleich der Subtraktion des ersten analogen Signals ($S_I$) von dem zweiten analogen Signal ($S_V$); und
- wenn das zweite analoge Signal ($S_V$) größer als das erste analoge Signal ($S_I$) ist, Ändern des Eingangssignals ($S_{AUDIO}$) durch Subtrahieren des dritten analogen Signals (RESIDUE).

2. Schaltung nach Anspruch 1, wobei die erste oder zweite Schaltung geeignet ist, dass wenigstens mindestens eines der ersten und/oder zweiten analogen Signale ($S_I$, $S_V$) in Bezug auf das andere normalisiert ist, so dass die ersten und zweiten Signale gleich sind, wenn der Lautsprecher einen Gleichstrom zieht.

3. Schaltung nach Anspruch 1 oder 2, wobei die zweite Schaltung (320) einen analogen Filter (320B) aufweist, der geeignet ist zum Verschieben der Phase des Ausgangssignals, um das zweite analoge Signal ($S_V$) zu erzeugen.

4. Schaltung nach Anspruch 3, wobei das dritte analoge Signal (RESIDUE) vor seiner Subtraktion von dem Eingangssignal ($S_{AUDIO}$) teilweise durch den Kompressor (514) komprimiert wird.

5. Schaltung nach Anspruch 4, wobei der Kompressor (514) geeignet ist, das dritte analoge Signal (RESIDUE) auf null zu setzen, wenn das erste analoge Signal ($S_I$) größer als das zweite analoge Signal ($S_V$) ist.

6. Schaltung nach Anspruch 4 oder 5, wobei der Kompressor (514) einen oder mehrere variable Widerstände (602, 604) in einem Leitungspfad des dritten analogen Signals aufweist, wobei der Widerstand des einen oder der mehreren variablen Widerstände basierend auf den Unterschieden iterativ ausgewählt wird.

7. Schaltung nach einem der Ansprüche 1 bis 6, wobei der Audioverstärker (314) ein Audioverstärker der Klasse D ist.

8. Ein System, das Folgendes aufweist:

einen Lautsprecher (316);
eine Verarbeitungsvorrichtung (304), die geeignet ist zum Erzeugen eines digitalen Audiostroms (AUDIO);
einen Digital-Analog-Wandler (310), der geeignet ist zum Erzeugen des Eingangssignals ($S_{AUDIO}$) basierend auf dem digitalen Audiostrom (AUDIO); und
die Schaltung nach einem der Ansprüche 1 bis 7, die geeignet ist den Lautsprecher (316) basierend auf dem Eingangssignal ($S_{AUDIO}$) anzusteuern.

9. Ein Verfahren, das Folgendes aufweist:

Verstärken eines Eingangssignals ($S_{AUDIO}$) durch einen Audioverstärker (314) zum Erzeugen eines Ausgangssignals ($S_{OUT+}$, $S_{OUT-}$), das zum Ansteuern eines Lautsprechers (316) geeignet ist;
Erzeugen eines ersten analogen Signals ($S_I$) durch eine erste Schaltung (318) basierend auf einem von dem Lautsprecher (316) gezogenen Strompegel; und
Erzeugen eines zweiten analogen Signals ($S_V$) durch eine zweite Schaltung (320) basierend auf einer über den Lautsprecher (316) angelegten Spannung, durch Normalisierung durch die erste Schaltung oder die zweite Schaltung wenigstens eines der ersten und/oder zweiten analogen Signale bezüglich zu dem anderen;
**dadurch gekennzeichnet, dass** das Verfahren ferner Folgendes aufweist:

Erzeugen eines dritten analogen Signals (RESIDUE) durch eine dritte Schaltung (322, 312) gleich der Subtraktion des ersten analogen Signals ($S_I$) von dem zweiten analogen Signal ($S_V$); und
wenn das zweite analoge Signal ($S_V$) größer als das erste analoge Signal ($S_I$) ist, Modifizieren des Eingangssignals ($S_{AUDIO}$) durch die dritte Schaltung (322, 312) durch Subtraktion des dritten analogen Signals (RESIDUE).

**Claims**

**1.** A circuit comprising:

an audio amplifier (314) adapted to amplify an input signal ($S_{AUDIO}$) to generate an output signal ($S_{OUT+}$, $S_{OUT-}$) suitable for driving a loud speaker (316);
a first circuit (318) adapted to generate a first analog signal ($S_I$) based on a current level drawn by the loud speaker (316); and
a second circuit (320) adapted to generate a second analog signal ($S_V$) based on a voltage supplied across the loud speaker (316),
**characterized in that** the circuit further comprises a third circuit (322, 312) adapted to:

- generate a third analog signal (RESIDUE) equal to the subtraction of the first analog signal ($S_I$) from the second analog signal ($S_V$); and
- when the second analog signal ($S_V$) is greater than the first analog signal ($S_I$), modify the input signal ($S_{AUDIO}$) by subtracting the third analog signal (RESIDUE).

**2.** The circuit of claim 1, wherein the first or the second circuit is adapted such that at least one of the first and second analog signals ($S_I$, $S_V$) is normalized with respect to the other so that the first and second signals are equal when the loud speaker draws a DC current.

**3.** The circuit of claim 1 or 2, wherein the second circuit (320) comprises an analog filter (320B) adapted to shift the phase of the output signal to generate the second analog signal ($S_V$).

**4.** The circuit of claim 3, wherein the third analog signal (RESIDUE) is partially compressed by the compressor (514) prior to its subtraction from the input signal ($S_{TUDIO}$).

**5.** The circuit of claim 4, wherein the compressor (514) is adapted to render the third analog signal (RESIDUE) null when the first analog signal ($S_I$) is greater than the second analog signal ($S_V$).

**6.** The circuit of claim 4 or 5, wherein the compressor (514) comprises one or more variable resistors (602, 604) in a conduction path of the third analog signal, the resistance of the one or more variable resistors being selected iteratively based on said difference.

**7.** The circuit of any of claims 1 to 6, wherein the audio amplifier (314) is a class D audio amplifier.

**8.** A system comprising:

a loud speaker (316);
a processing device (304) adapted to generate a digital audio stream (AUDIO);
a digital to analog converter (310) adapted to generate the input signal ($S_{AUDIO}$) based on said digital audio stream (AUDIO); and
the circuit of any of claims 1 to 7 adapted to drive the loud speaker (316) based on the input signal ($S_{AUDIO}$).

**9.** A method comprising:

amplifying, by an audio amplifier (314), an input signal ($S_{AUDIO}$) to generate an output signal ($S_{OUT+}$, $S_{OUT-}$) suitable for driving a loud speaker (316);
generating, by a first circuit (318), a first analog signal ($S_I$) based on a current level drawn by the loud speaker (316); and
generating, by a second circuit (320), a second analog signal ($S_V$) based on a voltage supplied across the loud speaker (316), by normalizing by the first circuit or the second circuit at least one of the first and second analog signals with respect to the other,
**characterized in that** the method further comprises:

generating, by a third circuit (322, 312), a third analog signal (RESIDUE) equal to the subtraction of the first analog signal ($S_I$) from the second analog signal ($S_V$); and
when the second analog signal ($S_V$) is greater than the first analog signal ($S_I$), modifying, by the third circuit (322, 312), the input signal ($S_{AUDIO}$) by subtracting the third analog signal (RESIDUE).

102
106
108
100
SOUT+
110
112
114
104
SOUT-
Fig 1
CURRENT LEVEL (dB)
0
-10
0,1
fR
1
10
kHz
Fig 2A
CURRENT PHASE
30
-30
0,1
fR
1
10
kHz
202
Fig 2B
300
308
304
AUDIO AMP
SOUT+
DSP
310
314
316
AUDIO
AUDIO
DAC
SAUDIO
312
302
306
SAUDIO'
RESIDUE
318
322
311
SI
320
SV
SOUT-
Fig 3

308
314
VDD
D-RAMP
410
405
312
413
403
SAUDIO+
ENTREE
SAUDIO-
406
414
408
SOUT+
412
404
407
409
SOUT-
D-RAMP
415
RESIDUE
418
RSENSE
416
318
322
422
420
COURANT
SI
GI=12.5
TENSION
426
320B
320A
424
SV
432
GV=0.125
430
428

Fig 4

308
508
405
506
VDD
D-RAMP
410
312
502
501
413
403
SAUDIO+
ENTREE
406
408
SOUT+
SAUDIO-
407
414
404
412
516
407
SI
504
SOUT-
SV
CTRL
514
409
510
D-RAMP
415
RESIDUE
RSENSE
416
418
512
RESIDUE
318
422
420
322
SI
GI=12.5
426
320B
320A
424
SV
432
GV=0.125
430
428

Fig 5

$S_I$
$S_V$
VCM/2
643
644
612
614
615
616
617
618
620
622
624
626
627
628
630
632
633
634
646
648
652
654
650
516
$V_{DD}$
637
$V_{REF}$
638
636
640
641
S'
Z -1
642
CLK
R
S
601
COMP64
COMP63
COMP62
COMP61
COMP04
COMP03
COMP02
COMP01
514
606
607
603
608
609
605
602
610
611
604

Fig 6

10,0000
5,0000
0,0000
-5,0000
FEEDBACK GAIN (dB)
-10,0000
-15,0000
-20,0000
-25,0000
-30,0000
-35,0000
COMP64
COMP63
COMP62
COMP61
COMP60
COMP59
COMP58
COMP57
COMP56
COMP55
COMP54
COMP53
COMP52
COMP51
COMP50
COMP49
COMP48
COMP47
COMP46
COMP45
COMP44
COMP43
COMP42
COMP41
COMP40
COMP39
COMP38
COMP37
COMP36
COMP35
COMP34
COMP33
COMP32
COMP31
COMP30
COMP29
COMP28
COMP27
COMP26
COMP25
COMP24
COMP23
COMP22
COMP21
COMP20
COMP19
COMP18
COMP17
COMP16
COMP15
COMP14
COMP13
COMP12
COMP11
COMP10
COMP09
COMP08
COMP07
COMP06
COMP05
COMP04
COMP03
COMP02
COMP01
CONTROL

Fig 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- WO 2008092111 A

### Littérature non-brevet citée dans la description

- **A. NAGARI et al.** An 8 Ω 2.5 W 1%-THD 10 4 dB(A)-Dynamic-Range Class-D Audio Amplifier With Ultra-Low EMI System and Current Sensing for Speaker Protection. *IEEE Journal of Solid-State Circuits,* Décembre 2012, vol. 47 (12